# EUROPÄISCHE PATENTANMELDUNG

(11) **EP 3 562 278 A1**
(43) Veröffentlichungstag der Anmeldung: **30.10.2019**
(21) Anmeldenummer: 18169233.6
(22) Anmeldetag: 25.04.2018
(51) Int. Cl.: H05K 3/20, H05K 3/46, H05K 3/02, H05K 3/10, H05K 3/28

(54) **HERSTELLEN EINER LEITERBAHNSTRUKTUR AUF EINER TRÄGERPLATTE**

(71) Anmelder: Siemens Aktiengesellschaft, 80333 München (DE)
(72) Erfinder: Beier, Axel, 16552 Schildow (DE); Lutz, Christoph, 91054 Erlangen (DE); Schiffel, Andre, 09474 Crottendorf (DE); Seidl, Joachim, 92237 Sulzbach-Rosenberg (DE); Steindl, Dieter, 92284 Poppenricht (DE)

(57) **Zusammenfassung**

Die Erfindung betrifft ein Verfahren zum Herstellen einer Leiterbahnstruktur auf einer Trägerplatte (1). Die Leiterbahnen (3) werden vorgefertigt, auf die Trägerplatte (1) aufgebracht und mit der Trägerplatte (1) verbunden.

## Beschreibung

Die Erfindung betrifft ein Verfahren zum Herstellen einer Leiterbahnstruktur auf einer Trägerplatte. Ferner betrifft die Erfindung eine Backplane zum elektrischen Verbinden elektrischer Bauelemente und einen Schaltschrank.

Unter einer Backplane wird hier ein Träger für elektrische Bauelemente verstanden, der Leiterbahnen zum elektrischen Verbinden der elektrischen Bauelemente aufweist. Derartige elektrische Bauelemente sind beispielsweise Schütze, Schalter, Steuerungseinheiten oder Eingabe-/Ausgabeeinheiten.

Bei bekannten Verfahren zum Herstellen von Leiterbahnstrukturen konventioneller Leiterplatten werden die Leiterbahnen durch lithografische und ätztechnische Verfahren aus einer geschlossenen Kupferoberfläche herausgearbeitet.

In einem Schaltschrank werden elektrische Bauelemente einer technischen Vorrichtung oder Anlage angeordnet. In herkömmlichen Schaltschränken werden elektrische Bauelemente in der Regel durch Kabel elektrisch miteinander verbunden. Bei einer Vielzahl elektrischer Bauelemente entsteht dabei ein hoher Verkabelungsaufwand.

DE 10 2016 002 052 A1 offenbart einen Schaltschrank und ein Verfahren zu dessen Herstellung. Der Schaltschrank weist zumindest eine Schalttafel mit einer Grundplatte auf, auf der elektrische Schaltelemente angeordnet und miteinander elektrisch verbunden sind. Die zumindest eine Grundplatte und/oder zumindest eines der Schaltelemente wird mittels eines 3D-Druckers in einem 3D-Druckverfahren hergestellt.

Der Erfindung liegt die Aufgabe zugrunde, ein verbessertes Verfahren zum Herstellen einer Leiterbahnstruktur auf einer Trägerplatte, insbesondere für eine Backplane eines Schaltschranks, anzugeben.

Die Aufgabe wird erfindungsgemäß durch ein Verfahren mit den Merkmalen des Anspruchs 1 gelöst.

Vorteilhafte Ausgestaltungen der Erfindung sind Gegenstand der abhängigen Ansprüche.

Bei dem erfindungsgemäßen Verfahren zum Herstellen einer Leiterbahnstruktur auf einer Trägerplatte werden Leiterbahnen vorgefertigt, auf die Trägerplatte aufgebracht und mit der Trägerplatte verbunden.

Das erfindungsgemäße Aufbringen vorgefertigter Leiterbahnen auf eine Trägerplatte hat den Vorteil, dass die Eigenschaften der Leiterbahnen bekannt und vorhersehbar sind. Es treten insbesondere keine Schwankungen der Leiterbahnqualität auf, die bei anderen Herstellungsprozessen entstehen können, beispielsweise bei einem Bedrucken einer Trägerplatte mit Leiterbahnen und anschließendem Aushärten der Leiterbahnen. Ferner ist die für das Aufbringen der Leiterbahnen auf die Trägerplatte erforderliche Zeit praktisch unabhängig von dem Querschnitt und insbesondere von der Dicke der Leiterbahnen.

Eine Ausgestaltung der Erfindung sieht vor, dass Leiterbahnen als ein aufgewickeltes Leiterband mit einer elektrisch leitenden Leitungsschicht vorgefertigt werden und das Leiterband zum Aufbringen einer Leiterbahn auf die Trägerplatte abgerollt, bei dem Abrollen auf die Trägerplatte geklebt und bei Erreichen einer vorgegebenen Leiterbahnlänge der Leiterbahn abgeschnitten wird. Beispielsweise weist das Leiterband eine außenseitige Klebeschicht auf und wird mit der Klebeschicht auf die Trägerplatte abgerollt, oder die Trägerplatte weist eine Klebeschicht auf, auf die das Leiterband abgerollt wird. Die Klebeschicht ist beispielsweise wärmehärtend und das Leiterband wird mit einem beheizten Andrückkopf auf die Trägerplatte abgerollt, wobei das Leiterband an die Trägerplatte angedrückt und die Klebeschicht wärmegehärtet wird, oder die Klebeschicht ist wärmeschmelzend und das Leiterband wird mit einem beheizten Andrückkopf auf die Trägerplatte abgerollt, wobei das Leiterband an die Trägerplatte angedrückt und die Klebeschicht wärmegeschmolzen wird.

Die vorgenannte Ausgestaltung der Erfindung ermöglicht beispielsweise auch die Herstellung von uneben verlaufenden Leiterbahnen. Eine wärmehärtende oder wärmeschmelzende Klebeschicht ist vorteilhaft, da die Klebeschicht erst durch einen Wärmeeintrag klebend wird und das Leiterband somit vor dem Auftragen auf die Trägerplatte gut handhabbar ist.

Eine weitere Ausgestaltung der Erfindung sieht vor, dass Leiterbahnen aus einer Leiterfolie, die eine elektrisch leitende Leitungsschicht aufweist, ausgeschnitten werden und auf die Trägerplatte geklebt werden. Beispielsweise weist die Leiterfolie eine außenseitige Klebeschicht auf, oder die Trägerplatte weist eine Klebeschicht auf, und die Lage der Leiterbahnen wird nach dem Ausschneiden aus der Leiterfolie beibehalten und die Trägerplatte wird zum Aufkleben der Leiterbahnen klebeschichtseitig auf die Leiterbahnen gelegt.

Die vorgenannte Ausgestaltung der Erfindung ermöglicht insbesondere, eine aus mehreren Leiterbahnen bestehende Leiterbahnstruktur aus einer Leiterfolie auszuschneiden und in einem einzigen Fertigungsschritt auf die Trägerplatte zu übertragen.

Bei allen vorgenannten Ausgestaltungen der Erfindung kann die Klebeschicht beispielsweise elektrisch isolierend sein, oder eine der Klebeschicht zugewandte Oberfläche der Leitungsschicht kann mit einer Isolationsschicht beschichtet sein. Dies ist insbesondere vorteilhaft, wenn die Trägerplatte zumindest teilweise aus einem elektrisch leitfähigen Material gefertigt ist, um einen elektrischen Kontakt der Leiterbahnen mit der Trägerplatte zu vermeiden.

Ferner kann bei allen vorgenannten Ausgestaltungen der Erfindung eine von der Klebeschicht abgewandte Oberfläche der Leitungsschicht mit einer Isolationsschicht beschichtet sein. Dadurch kann insbesondere ein elektrischer Kontakt zwischen sich kreuzenden Leiterbahnen verhindert werden. Außerdem werden die Leiterbahnen dadurch gegenüber ihrer Umgebung elektrisch isoliert und beispielsweise gegen schädigende Auswirkungen unabsichtlichen Berührens geschützt.

Eine weitere Ausgestaltung der Erfindung sieht vor, dass die Trägerplatte in einem additiven Fertigungsverfahren, beispielsweise mit einem 3D-Druck, hergestellt wird und vorgefertigte Leiterbahnen während der Herstellung der Trägerplatte in die Trägerplatte integriert werden. Beispielsweise werden während der Herstellung der Trägerplatte Aussparungen in der Trägerplatte für die Leiterbahnen erzeugt und die Leiterbahnen werden in die Aussparungen eingelegt. Ferner können die Aussparungen nach dem Einlegen der Leiterbahnen in die Aussparungen im weiteren Fertigungsprozess der Trägerplatte wenigstens teilweise verschlossen werden.

Unter einem 3D-Druck wird ein Verfahren verstanden, bei dem ein dreidimensionales Objekt durch computergesteuertes schichtweises Auftragen von Material hergestellt wird. Die vorgenannte Ausgestaltung der Erfindung ermöglicht die Herstellung der Leiterbahnstruktur während der Fertigung der Trägerplatte. Insbesondere können die Leiterbahnen bei der Fertigung der Trägerplatte in die Trägerplatte eingebettet werden, so dass kein zusätzliches Fixieren der Leiterbahnen an der Trägerplatte erforderlich ist. Durch das Einlegen der Leiterbahnen in Aussparungen und ein anschließendes zumindest teilweises Verschließen der Aussparungen können die Leiterbahnen ferner elektrisch isoliert werden und es kann ein Angleichen der Höhenniveaus auf der Trägerplatte erreicht werden. Ein nur teilweises Verschließen von Aussparungen ermöglicht beispielsweise, Kontaktbereiche von Leiterbahnen frei zugänglich zu halten, um die Leiterbahnen in den Kontaktbereichen elektrisch kontaktieren zu können.

Eine weitere Ausgestaltung der Erfindung sieht vor, dass die Leiterbahnstruktur mehrere übereinander angeordnete Leiterbahnebenen aufweist, in denen jeweils wenigstens eine Leiterbahn verläuft, und dass die Trägerplatte wenigstens eine Ausnehmung aufweist, die wenigstens zwei Leiterbahnebenen verbindet. Dies ermöglicht, Leiterbahnen in verschiedenen Leiterbahnebenen anzuordnen und durch Durchkontaktierungen zu verbinden.

Eine erfindungsgemäße Backplane zum elektrischen Verbinden elektrischer Bauelemente umfasst eine Trägerplatte mit einer Leiterbahnstruktur, die mit dem erfindungsmäßen Verfahren gefertigt ist. Ein erfindungsgemäßer Schaltschrank weist eine erfindungsgemäße Backplane auf. Die Vorteile einer derartigen Backplane und eines derartigen Schaltschranks ergeben sich aus den oben genannten Vorteilen des erfindungsgemäßen Verfahrens.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: schematisch ein Aufkleben eines Leiterbandes auf einen ebenen Abschnitt einer Trägerplatte,
- FIG 2: eine Schnittdarstellung eines Leiterbandes,
- FIG 3: schematisch ein Aufkleben eines Leiterbandes auf einen Abschnitt einer Trägerplatte mit einer Kontaktnase,
- FIG 4: eine Schnittdarstellung einer Trägerplatte mit einer Leiterbahn und eines Federkontakts eines elektrischen Bauelements,
- FIG 5: eine Draufsicht auf eine eingeschnittene Leiterfolie,
- FIG 6: eine Schnittdarstellung einer Leiterfolie auf einer Schneidunterlage,
- FIG 7: eine Schnittdarstellung einer aus einer Leiterfolie ausgeschnittenen Leiterbahn zwischen einer Schneidunterlage und einer Trägerplatte,
- FIG 8: eine Schnittdarstellung einer Trägerplatte mit einer aus einer Leiterfolie ausgeschnittenen Leiterbahn,
- FIG 9: eine perspektivische Darstellung einer Aussparung in einer Trägerplatte,
- FIG 10: eine Schnittdarstellung einer Aussparung in einer Trägerplatte,
- FIG 11: eine perspektivische Darstellung einer vorgefertigten Leiterbahn,
- FIG 12: eine perspektivische Darstellung einer vorgefertigten Leiterbahn, die in eine Aussparung in einer Trägerplatte eingelegt ist,
- FIG 13: eine Schnittdarstellung einer vorgefertigten Leiterbahn, die in eine Aussparung in einer Trägerplatte eingelegt ist,
- FIG 14: eine perspektivische Darstellung einer vorgefertigten Leiterbahn, die in eine Trägerplatte eingebettet ist,
- FIG 15: eine Schnittdarstellung einer vorgefertigten Leiterbahn, die in eine Trägerplatte eingebettet ist,
- FIG 16: eine perspektivische Darstellung eines Schaltschranks.

Einander entsprechende Teile sind in den Figuren mit denselben Bezugszeichen versehen.

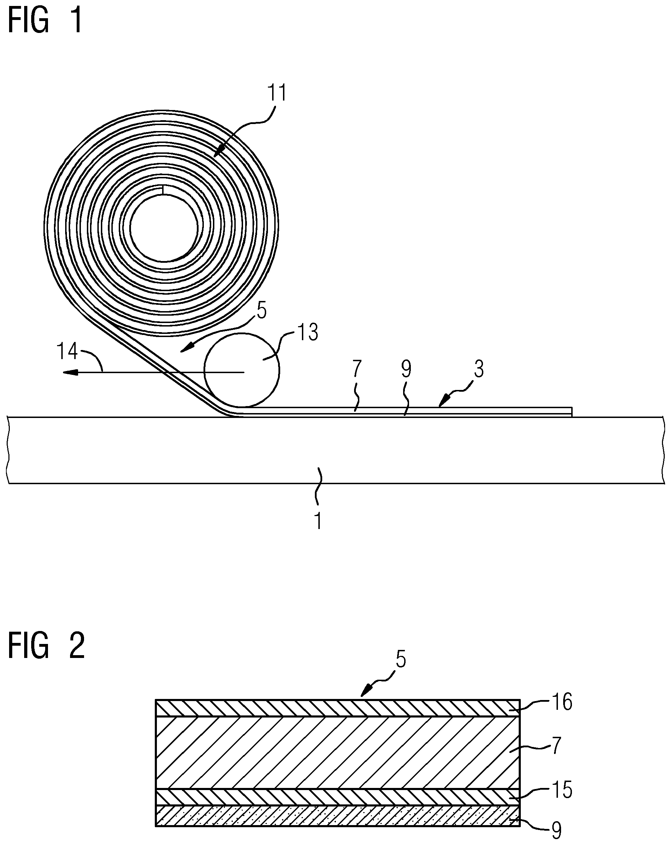

Die Figuren 1 bis 4 illustrieren ein erstes Ausführungsbeispiel eines Verfahrens zum Herstellen einer Leiterbahnstruktur auf einer Trägerplatte 1. Bei diesem Ausführungsbeispiel werden Leiterbahnen 3 als ein aufgewickeltes Leiterband 5 mit einer elektrisch leitenden Leitungsschicht 7 und einer außenseitigen Klebeschicht 9 vorgefertigt. Das Leiterband 5 wird zum Aufbringen einer Leiterbahn 3 mit seiner Klebeschicht 9 auf die Trägerplatte 1 abgerollt, bei dem Abrollen auf die Trägerplatte 1 geklebt und bei Erreichen einer vorgegebenen Leiterbahnlänge der Leiterbahn 3 abgeschnitten.

Figur 1 zeigt das Aufkleben des Leiterbandes 5 auf einen ebenen Abschnittes einer Trägerplatte 1 in einer Schnittdarstellung. Das Leiterband 5 ist auf eine Vorratsspule 11 aufgewickelt und wird mit einem bewegbaren Andrückkopf 13 auf die Trägerplatte 1 abgerollt, wobei die Klebeschicht 9 an die Trägerplatte 1 angedrückt wird. Dabei wird der Andrückkopf 13 in einer Abrollrichtung 14 bewegt.

Der Andrückkopf 13 ist beispielsweise als eine Andrückrolle ausgebildet.

Die Leitungsschicht 7 ist beispielsweise eine Kupferschicht.

Die Klebeschicht 9 ist beispielsweise wärmehärtend oder wärmeschmelzend und der Andrückkopf 13 ist beheizbar ausgebildet. Beim Abrollen des Leiterbandes 5 wird der Andrückkopf 13 beheizt und dadurch die Klebeschicht 9 im Bereich des Andrückkopfes 13 wärmegehärtet oder wärmegeschmolzen und das Leiterband 5 auf die Trägerplatte 1 geklebt.

Figur 2 zeigt eine Schnittdarstellung eines Ausführungsbeispiels des Leiterbandes 5. Dieses Ausführungsbeispiel des Leiterbandes 5 weist neben der Leitungsschicht 7 und der Klebeschicht 9 zwei Isolationsschichten 15, 16 auf, mit denen die Leitungsschicht 7 beschichtet ist, wobei eine der Klebeschicht 9 zugewandte Oberfläche der Leitungsschicht 7 mit einer ersten Isolationsschicht 15 beschichtet ist und eine von der Klebeschicht 9 abgewandte Oberfläche der Leitungsschicht 7 mit einer zweiten Isolationsschicht 16 beschichtet ist.

Andere Ausführungsbeispiele des Leiterbandes 5 können beispielsweise nur eine Isolationsschicht 15, 16 oder gar keine Isolationsschicht 15, 16 aufweisen. Beispielsweise kann die Klebeschicht 9 elektrisch isolierend ausgebildet sein, so dass keine zusätzliche Isolationsschicht 15 zwischen der Klebeschicht 9 und der Leitungsschicht 7 erforderlich ist.

Bei einem anderen Ausführungsbeispiel kann auch die zweite Isolationsschicht 16 mit einer Klebeschicht 9 beschichtet sein. Dadurch kann beispielsweise die Richtung einer Leiterbahn 3 durch ein Umfalten des Leiterbandes 5 geändert werden.

Wenn die Leitungsschicht 7 beidseitig beschichtet ist, wird die Beschichtung auf der von der Trägerplatte 1 abgewandten Oberfläche der Leitungsschicht 7 im Bereich von Kontaktierungsbereichen entfernt, an denen die Leitungsschicht 7 elektrisch kontaktiert werden soll.

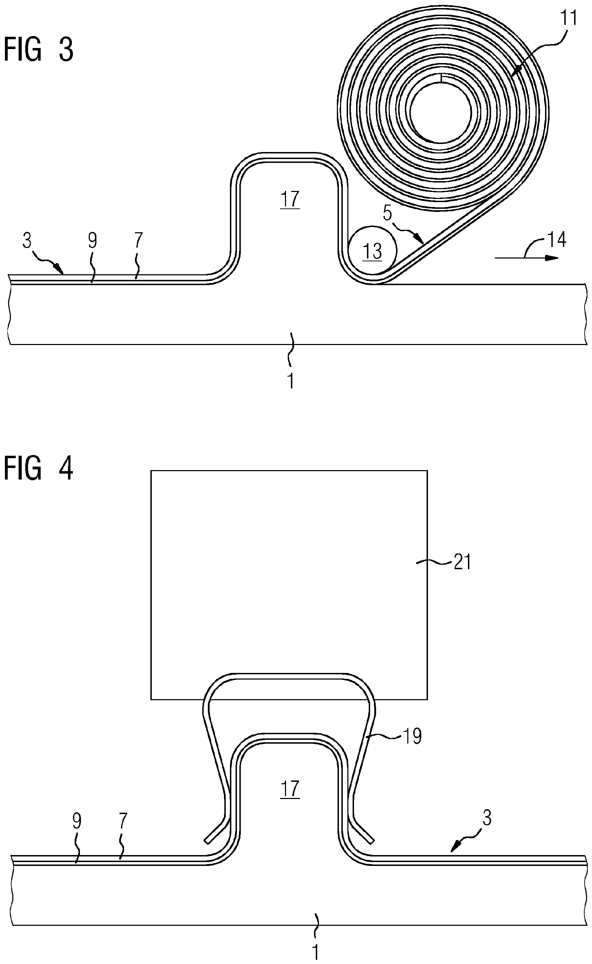

Figur 3 zeigt schematisch ein Aufkleben des Leiterbandes 5 auf einen Abschnitt einer Trägerplatte 1, der eine Kontaktnase 17 aufweist, über die eine Leiterbahn 3 geführt wird. Dabei wird die Andrückrolle 13 über die Kontaktnase 17 gerollt und dabei das Leiterband 5 mit der Klebeschicht 9 an die Kontaktnase 17 gedrückt und auf die Kontaktnase 17 geklebt. Das Leiterband 5 kann zusätzlich zu der Leitungsschicht 7 und der Klebeschicht 9 eine zwischen der Leitungsschicht 7 und der Klebeschicht 9 angeordnete Isolationsschicht 15 aufweisen.

Figur 4 zeigt die Trägerplatte 1 mit der Leiterbahn 3 im Bereich der Kontaktnase 17, wobei die Leiterbahn 3 durch einen auf die Kontaktnase 17 geklemmten Federkontakt 19 mit einem elektrischen Bauelement 21 elektrisch verbunden ist.

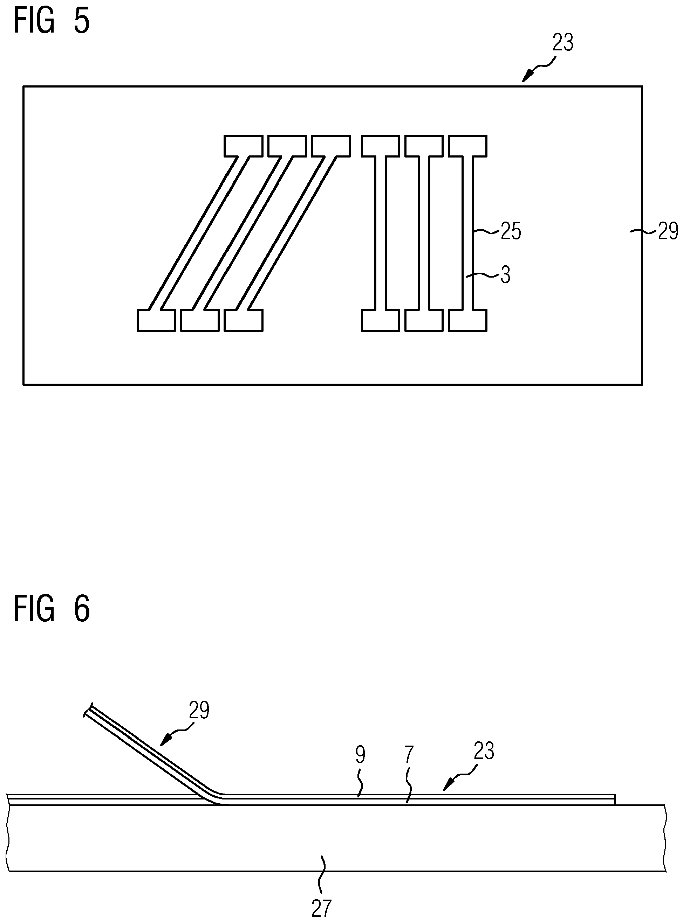

Die Figuren 5 bis 8 illustrieren ein zweites Ausführungsbeispiel eines Verfahrens zum Herstellen einer Leiterbahnstruktur auf einer Trägerplatte 1. Bei diesem Ausführungsbeispiel wird die Leiterbahnstruktur aus einer Leiterfolie 23 ausgeschnitten und auf die Trägerplatte geklebt.

Die Leiterfolie 23 ist wie ein Leiterband 5 des anhand der Figuren 1 bis 4 beschriebenen Ausführungsbeispiels aufgebaut: die Leiterfolie 23 weist eine elektrisch leitende Leitungsschicht 7 und eine außenseitige Klebeschicht 9 auf und kann ferner analog zu Figur 2 eine zwischen der Leitungsschicht 7 und der Klebeschicht 9 angeordnete erste Isolationsschicht 15 und/oder eine auf einer von der Klebeschicht 9 abgewandten Oberfläche der Leitungsschicht 7 aufgebrachte zweite Isolationsschicht 16 aufweisen, wobei die zweite Isolationsschicht 16 außenseitig ebenfalls mit einer Klebeschicht 9 beschichtet sein kann.

Figur 5 zeigt eine Draufsicht auf eine Leiterfolie 23. Die Leiterfolie 23 weist Einschnitte 25 auf, die die Leiterbahnen 3 beranden. Die Leiterfolie 23 wird beispielsweise mit einem Laser eingeschnitten. Die Leiterbahnen 3 bilden die auf die Trägerplatte 1 zu klebende Leiterbahnstruktur.

Figur 6 zeigt eine Schnittdarstellung einer Leiterfolie 23 auf einer Schneidunterlage 27, auf der die Leiterfolie 23 eingeschnitten wird. Die Klebeschicht 9 bildet die der Schneidunterlage 27 abgewandte Seite der Leiterfolie 23. Nach dem Einschneiden der Leiterfolie 23 wird der zu den Leiterbahnen 3 komplementäre Komplementärbereich 29 der Leiterfolie 23 von der Schneidunterlage 27 entfernt, wobei die ausgeschnittenen Leiterbahnen 3 auf der Schneidunterlage 27 verbleiben.

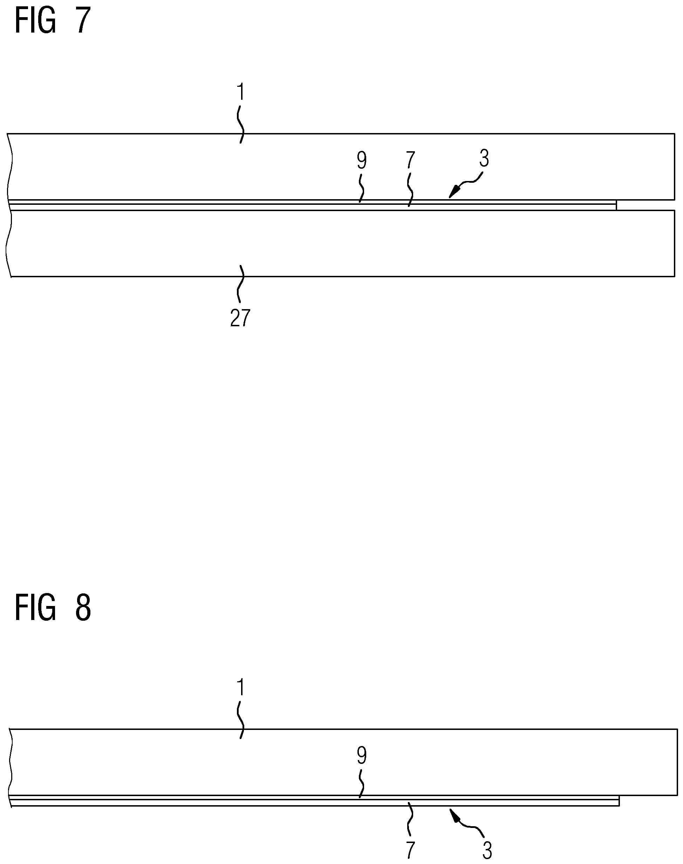

Nach dem Entfernen des Komplementärbereiches 29 wird die Trägerplatte 1 auf die auf der Schneidunterlage 27 liegenden ausgeschnittenen Leiterbahnen 3 gelegt und die Leiterbahnen 3 werden auf die Trägerplatte 1 geklebt. Figur 7 zeigt eine Schnittdarstellung einer aus einer Leiterfolie 23 ausgeschnittenen Leiterbahn 3 zwischen der Schneidunterlage 27 und der Trägerplatte 1.

Die Leiterbahnen 3 werden beispielsweise durch Druck und/oder Wärmeeintrag auf die Trägerplatte 1 geklebt, wobei der Druck beispielsweise durch Andrücken der Trägerplatte 1 an die Leiterbahnen 3 erzeugt wird und der Wärmeeintrag beispielsweise durch Beheizen der Schneidunterlage 27 erzeugt wird. Beispielsweise ist die Klebeschicht 9 wärmehärtend oder wärmeschmelzend und wird durch den Wärmeeintrag wärmegehärtet oder wärmegeschmolzen.

Figur 8 zeigt eine Schnittdarstellung der Trägerplatte 1 und einer aus einer Leiterfolie 23 ausgeschnittenen Leiterbahn 3 nach dem Aufkleben der Leiterbahnen 3 auf die Trägerplatte 1.

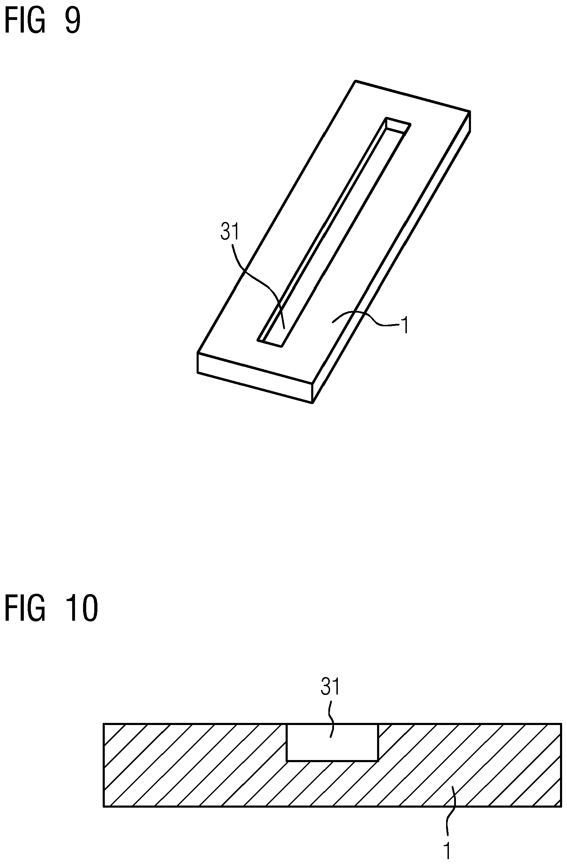

Die Figuren 9 bis 15 illustrieren ein drittes Ausführungsbeispiel eines Verfahrens zum Herstellen einer Leiterbahnstruktur auf einer Trägerplatte 1. Bei diesem Ausführungsbeispiel wird die Trägerplatte 1 in einem additiven Fertigungsverfahren hergestellt und vorgefertigte Leiterbahnen 3 werden während der Herstellung der Trägerplatte 1 in die Trägerplatte 1 integriert. Beispielsweise wird die Trägerplatte 1 mit einem 3D-Druck hergestellt. Während der Herstellung der Trägerplatte 1 werden Aussparungen 31 in der Trägerplatte 1 für die Leiterbahnen 3 erzeugt und die Leiterbahnen 3 werden in die Aussparungen 31 eingelegt. Nach dem Einlegen der Leiterbahnen 3 in die Aussparungen 31 werden die Aussparungen 31 im weiteren Fertigungsverfahren der Trägerplatte 1 teilweise verschlossen.

Die Figuren 9 und 10 zeigen eine Aussparung 31 in einer Trägerplatte 1 vor dem Einlegen einer Leiterbahn 3 in die Aussparung 31. Dabei zeigt Figur 9 eine perspektivische Darstellung und Figur 10 zeigt eine Schnittdarstellung der Aussparung 31.

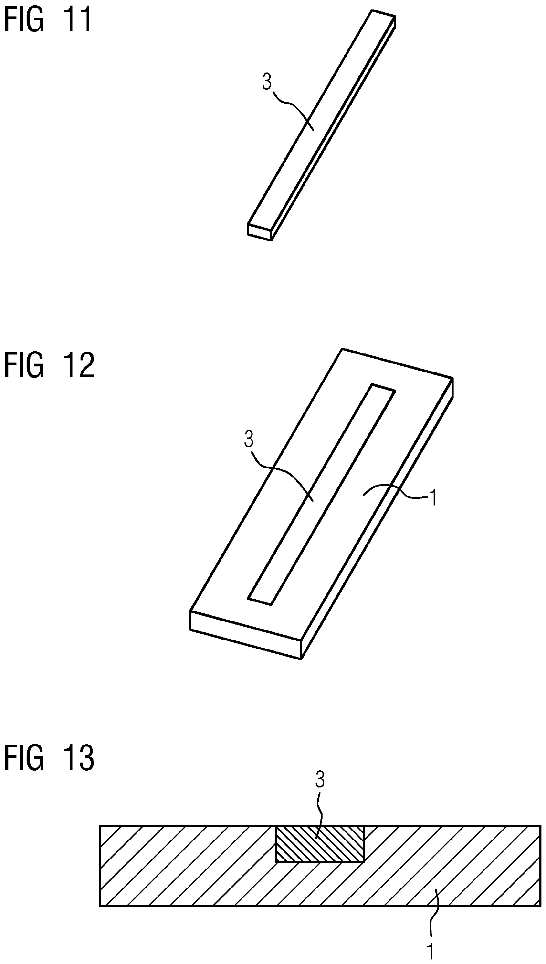

Figur 11 zeigt eine perspektivische Darstellung einer vorgefertigten Leiterbahn 3. Die Leiterbahn 3 kann beispielsweise analog zu dem anhand der Figuren 1 bis 4 beschriebenen Ausführungsbeispiel von einer Vorratsspule 11 abgewickelt und abgeschnitten werden oder analog zu dem anhand der Figuren 5 bis 8 beschriebenen Ausführungsbeispiel aus einer Leiterfolie 23 ausgeschnitten werden.

Die Figuren 12 und 13 zeigen eine vorgefertigte Leiterbahn 3, die in eine Aussparung 31 in der Trägerplatte 1 eingelegt ist. Dabei zeigt Figur 12 eine perspektivische Darstellung und Figur 13 zeigt eine Schnittdarstellung der eingelegten Leiterbahn 3.

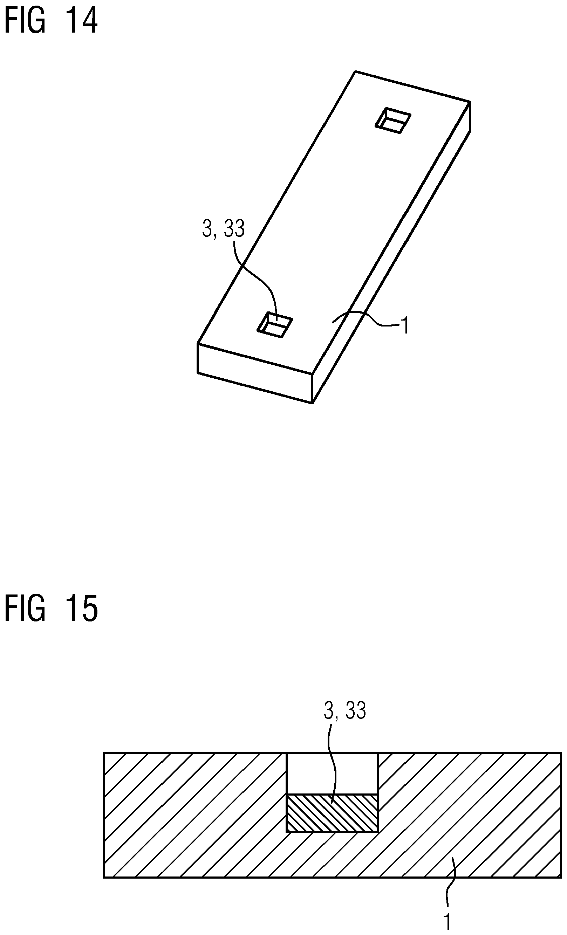

Die Figuren 14 und 15 zeigen eine vorgefertigte Leiterbahn 3, die in eine Aussparung 31 in der Trägerplatte 1 eingelegt ist, nachdem die Aussparung 31 teilweise verschlossen wurde. Dabei zeigt Figur 14 eine perspektivische Darstellung und Figur 15 zeigt eine Schnittdarstellung der teilweise verschlossenen Trägerplatte 1 mit der integrierten Leiterbahn 3.

Zum teilweisen Verschließen der Aussparung 31 wird weiteres Material auf die Trägerplatte 1 aufgebracht, das die Leiterbahn 3 bis auf Kontaktbereiche 33 bedeckt. Die Kontaktbereiche 33 sind beispielsweise Endbereiche der Leiterbahn 3. An den Kontaktbereichen 33 kann die Leiterbahn 3 elektrisch kontaktiert werden.

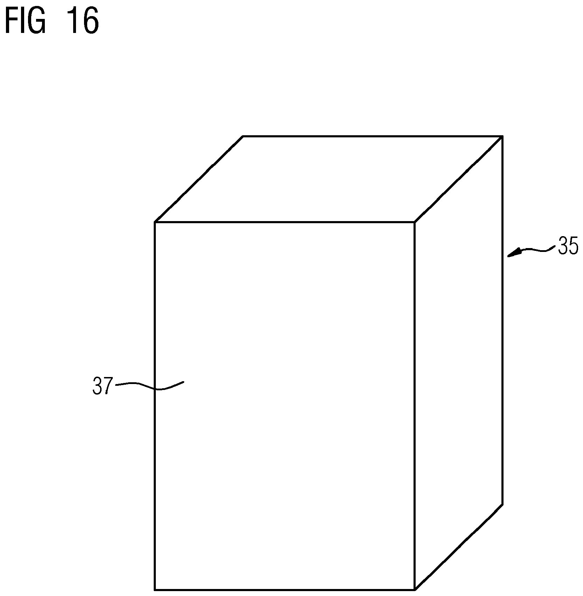

Figur 16 zeigt eine perspektivische Darstellung eines Schaltschranks 35. Der Schaltschrank 35 weist eine Backplane 37 auf, die eine Rückwand des Schaltschranks 35 bildet. Die Backplane 37 weist eine Trägerplatte 1 mit einer Leiterbahnstruktur auf, die mit einem der anhand der Figuren 1 bis 15 beschriebenen Ausführungsbeispiele des erfindungsgemäßen Verfahrens gefertigt ist.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Herstellen einer Leiterbahnstruktur auf einer Trägerplatte (1), wobei Leiterbahnen (3) vorgefertigt, auf die Trägerplatte (1) aufgebracht und mit der Trägerplatte (1) verbunden werden.

2. Verfahren nach Anspruch 1,
**dadurch gekennzeichnet, dass** Leiterbahnen (3) als ein aufgewickeltes Leiterband (5) mit einer elektrisch leitenden Leitungsschicht (7) vorgefertigt werden und das Leiterband (5) zum Aufbringen einer Leiterbahn (3) auf die Trägerplatte (1) abgerollt, bei dem Abrollen auf die Trägerplatte (1) geklebt und bei Erreichen einer vorgegebenen Leiterbahnlänge der Leiterbahn (3) abgeschnitten wird.

3. Verfahren nach Anspruch 2,
**dadurch gekennzeichnet, dass** das Leiterband (5) eine außenseitige Klebeschicht (9) aufweist und mit der Klebeschicht (9) auf die Trägerplatte (1) abgerollt wird, oder dass die Trägerplatte (1) eine Klebeschicht (9) aufweist, auf die das Leiterband (5) abgerollt wird.

4. Verfahren nach Anspruch 3,
**dadurch gekennzeichnet, dass** die Klebeschicht (9) wärmehärtend ist und das Leiterband (5) mit einem beheizten Andrückkopf (13) auf die Trägerplatte (1) abgerollt wird, wobei das Leiterband (5) an die Trägerplatte (1) angedrückt und die Klebeschicht (9) wärmegehärtet wird.

5. Verfahren nach Anspruch 3,
**dadurch gekennzeichnet, dass** die Klebeschicht (9) wärmeschmelzend ist und das Leiterband (5) mit einem beheizten Andrückkopf (13) auf die Trägerplatte (1) abgerollt wird, wobei das Leiterband (5) an die Trägerplatte (1) angedrückt und die Klebeschicht (9) wärmegeschmolzen wird.

6. Verfahren nach einem der vorhergehenden Ansprüche,
**dadurch gekennzeichnet, dass** Leiterbahnen (3) aus einer Leiterfolie (23), die eine elektrisch leitende Leitungsschicht (7) aufweist, ausgeschnitten werden und auf die Trägerplatte (1) geklebt werden.

7. Verfahren nach Anspruch 6,
**dadurch gekennzeichnet, dass** die Leiterfolie (23) eine außenseitige Klebeschicht (9) aufweist, oder dass die Trägerplatte (1) eine Klebeschicht (9) aufweist, und dass die Lage der Leiterbahnen (3) nach dem Ausschneiden aus der Leiterfolie (23) beibehalten wird und die Trägerplatte (1) zum Aufkleben der Leiterbahnen (3) klebeschichtseitig auf die Leiterbahnen (3) gelegt wird.

8. Verfahren nach einem der Ansprüche 3 bis 5 oder 7,
**dadurch gekennzeichnet, dass** die Klebeschicht (9) elektrisch isolierend ist.

9. Verfahren nach einem der Ansprüche 2 bis 7,
**dadurch gekennzeichnet, dass** wenigstens eine Oberfläche der Leitungsschicht (7) mit einer Isolationsschicht (15, 16) beschichtet ist.

10. Verfahren nach einem der vorhergehenden Ansprüche,
**dadurch gekennzeichnet, dass** die Trägerplatte (1) in einem additiven Fertigungsverfahren hergestellt wird und vorgefertigte Leiterbahnen (3) während der Herstellung der Trägerplatte (1) in die Trägerplatte (1) integriert werden.

11. Verfahren nach Anspruch 10,
**dadurch gekennzeichnet, dass** während der Herstellung der Trägerplatte (1) Aussparungen (31) in der Trägerplatte (1) für die Leiterbahnen (3) erzeugt werden und die Leiterbahnen (3) in die Aussparungen (31) eingelegt werden.

12. Verfahren nach Anspruch 11,
**dadurch gekennzeichnet, dass** die Aussparungen (31) nach dem Einlegen der Leiterbahnen (3) im weiteren Fertigungsverfahren der Trägerplatte (1) wenigstens teilweise verschlossen werden.

13. Verfahren nach einem der vorhergehenden Ansprüche,
**dadurch gekennzeichnet, dass** die Leiterbahnstruktur mehrere übereinander angeordnete Leiterbahnebenen aufweist, in denen jeweils wenigstens eine Leiterbahn (3) verläuft, und dass die Trägerplatte (1) wenigstens eine Ausnehmung aufweist, die wenigstens zwei Leiterbahnebenen verbindet.

14. Backplane (37) zum elektrischen Verbinden elektrischer Bauelemente (21), die Backplane (37) umfassend eine Trägerplatte (1) mit einer Leiterbahnstruktur, die mit einem Verfahren nach einem der vorhergehenden Ansprüche gefertigt ist.

15. Schaltschrank (35) mit einer gemäß Anspruch 14 ausgebildeten Backplane (37).
